# EUROPEAN PATENT APPLICATION

(11) **EP 2 086 017 A1**
(43) Date of publication of application: **05.08.2009**
(21) Application number: 07828448.6
(22) Date of filing: 26.09.2007
(51) Int. Cl.: H01L 31/04, H01L 31/042

(54) **BLACK CERAMIC DECORATED SOLAR BATTERY MODULE**

(30) Priority: 28.09.2006 JP 2006264259
(71) Applicant: Showa Shell Sekiyu Kabushiki Kaisha, Minato-ku Tokyo 135-8074 (JP)
(72) Inventor: TSUNODA, Mayuki, Tokyo 135-8074 (JP); TAZAWA, Kenichi, Tokyo 135-8074 (JP); SUZUKI, Hirohisa, Tokyo 135-8074 (JP)
(74) Representative: HOFFMANN EITLE
(86) International application number: PCT/JP2007/068702
(87) International publication number: WO 2008/038673

(57) **Abstract**

The electrode parts of a solar cell module which differ in color form other parts of the module are hidden without increasing the number of module assembly/production steps to thereby enable the whole CIS based thin-film solar cell module to have an even color throughout and hence an improved appearance.

A solar cell module 1 having a beautiful appearance is provided which includes a submodule 3 having the same color as electrode parts 3A of the submodule. A black ceramic layer 7 having almost the same color as the submodule 3 is formed on the back side (lower side) of peripheral edge parts of a cover glass 4. The silver-white electrode parts 3A formed in peripheral areas of the submodule 3 are hidden by the black ceramic layer 7, whereby the whole module 1 has an even color throughout and has an improved appearance. For a baking operation for forming the black ceramic layer 7, the heating performed when the cover glass 4 is produced through tempering by a heat treatment may be utilized.

## Description

### TECHNICAL FIELD

The present invention relates to a black-ceramic-decorated solar cell module which includes a cover glass having a black ceramic layer formed in a peripheral edge part of the back side of the cover glass.

### BACKGROUND ART

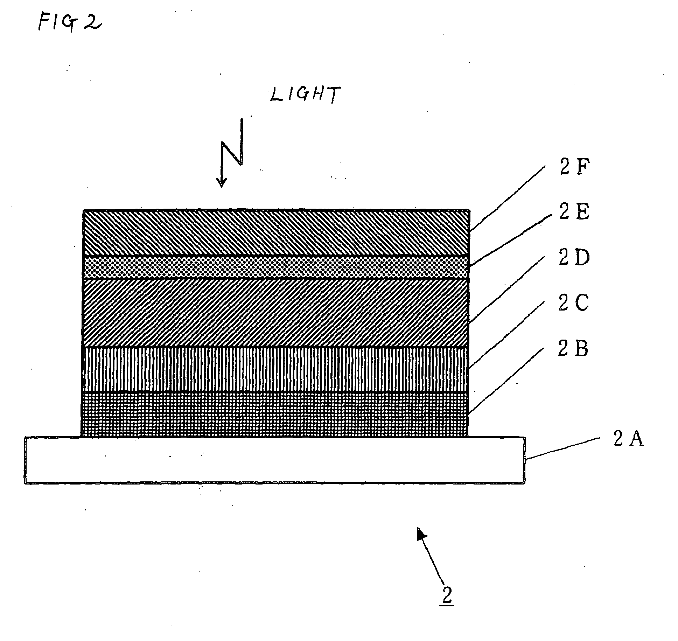

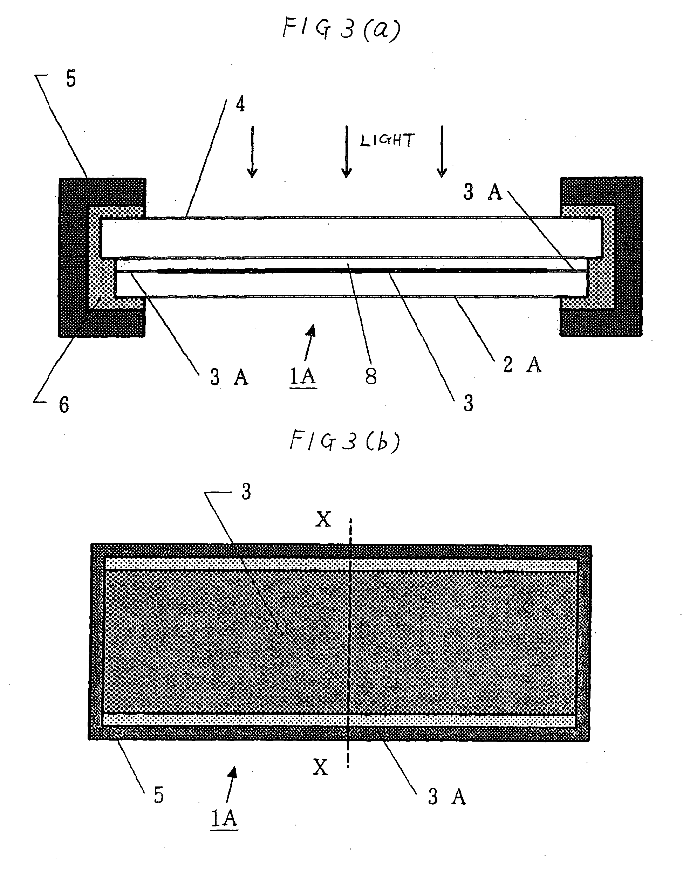

As shown in Fig. 3, a general conventional CIS based thin-film solar cell module 1A has a structure obtained by fitting an aluminum frame 5 through a sealing material 6 to peripheral edge parts of an assembly obtained by bonding (attaching) a cover glass 4 through a filling material 8 to a CIS based thin-film solar cell submodule 3 (composed of devices 2 each shown in Fig. 2 which have been electrically connected by patterning) formed on a glass substrate 2A. As shown in Fig. 3 (a) and (b), electrodes 3A have been disposed on the periphery of the solar cell submodule 3 surrounded by the aluminum frame 5. When the CIS based thin-film solar cell module 1A having such a structure is viewed, then the aluminum frame 5 and the electrodes 3A and solar cell submodule 3, which are located inside the frame 5, are recognized. Although the aluminum frame 5 has been colored in the same tint (blackish brown) as the solar cell submodule 3, the electrodes 3A has a silver-white color. Because of this, the electrode 3A parts only have a different color. There has hence been a problem that the module as a whole has an uneven color and this impairs the appearance of the solar cell module 1A as shown in Fig. 3 (b).

With regard to solar cells, there is a technique in which protrudent parts are formed on a surface of a colorless and transparent float glass (white flat glass) by the screen printing of a ceramic ink to thereby cause irregular light reflection and increase the quantity of light received (see, for example, patent document 1). However, these protrudent parts 4 formed from a ceramic ink on the glass surface are not intended to hide the electrode parts to impart a beautiful appearance.

Known black ceramic materials are ones obtained by compounding zirconia or alumina as a main ingredient with 5-20% by weight one or more coloring materials selected from manganese dioxide, triiron tetroxide, cobalt oxide, nickel oxide, and chromium oxide and burning the composition (see, for example, patent document 2).

As described above, there has been no idea concerning such a conventional CIS based thin-film solar cell module 1A that the silver-white electrode 3A parts are hidden to cause the whole CIS based thin-film solar cell module 1A to have an even color throughout and hence have an improved appearance.

A technique may be usable in which the silver-white electrode 3A parts are hidden by coating with a black coating material, Magic Ink, or the like or applying a black resin (PVC) tape or the like to thereby cause the whole CIS based thin-film solar cell module 1A to have an even color throughout and hence have an improved appearance. However, this technique has a drawback that the steps for solar cell production additionally necessitate such a step and become complicated, leading to an increase in production cost.

Patent Document 1: JP-A-2001-298202
Patent Document 2: JP-A-7-56070

### DISCLOSURE OF THE INVENTION

### PROBLEM THAT THE INVENTION IS TO SOLVE

The invention eliminates the problem described above. An object of the invention is to hide electrode parts of a solar cell module, which differ in color from other parts of the module, without increasing the number of module assembly/production steps and thereby enable the whole CIS based thin-film solar cell module to have an even color throughout and hence have an improved appearance. Another object is to enable the front side and back side of a cover glass 4 to be easily distinguished from each other without fail in a cover glass disposition operation.

### MEANS FOR SOLVING THE PROBLEM

(1) The invention provides a black-ceramic-decorated solar cell module which is a solar cell module having a structure constituted of: a CIS based thin-film solar cell submodule including a glass substrate and, disposed on the glass substrate, CIS based thin-film solar cell device parts which each include superposed layers constituted of a metallic back electrode layer, a CIS based light absorption layer, a buffer layer, and a window layer in this order and which have been electrically connected to each other with a conductive pattern; a tempered cover glass disposed over the upper side of the solar cell submodule; and a back sheet disposed on the back side of the glass substrate through a filling material,
wherein the cover glass has a black ceramic layer which has almost the same color as the solar cell submodule and is located in a peripheral edge part on at least one side of the cover glass and over a silver-white electrode part formed in a peripheral area of the solar cell submodule to thereby hide the electrode part.

(2) The invention provides the black-ceramic-decorated solar cell module, wherein the black ceramic layer has been formed in a peripheral edge part on that side of the cover glass which is in contact with the electrode part of the solar cell submodule.

(3) The invention provides the black-ceramic-decorated solar cell module, wherein the black ceramic layer is one formed by screen-printing an ink prepared by mixing a glass ingredient and a pigment ingredient with a solvent and baking the ink applied.

(4) The invention provides the black-ceramic-decorated solar cell module, wherein the glass ingredient for the black ceramic layer includes at least either of bismuth oxide and diboron trioxide and further includes silica (SiO₂) or the like, the pigment ingredient includes at least either of manganese dioxide and chromium oxide, and the solvent includes a terpene solvent.

(5) The invention provides the black-ceramic-decorated solar cell module according to any one of (1) to (4) above, wherein the baking for forming the black ceramic layer is conducted by utilizing the heating performed when the tempered cover glass is produced through tempering by a heat treatment.

### ADVANTAGES OF THE INVENTION

According to the invention, electrode parts of a solar cell module, which differ in color from other parts of the module, can be hidden without increasing the number of module assembly/production steps to thereby enable the whole CIS based thin-film solar cell module to have an even color throughout and hence have an improved appearance. In addition, the front side and back side of a cover glass 4 can be easily distinguished from each other without fail in a cover glass disposition operation.

### BRIEF DESCRIPTION OF THE DRAWINGS

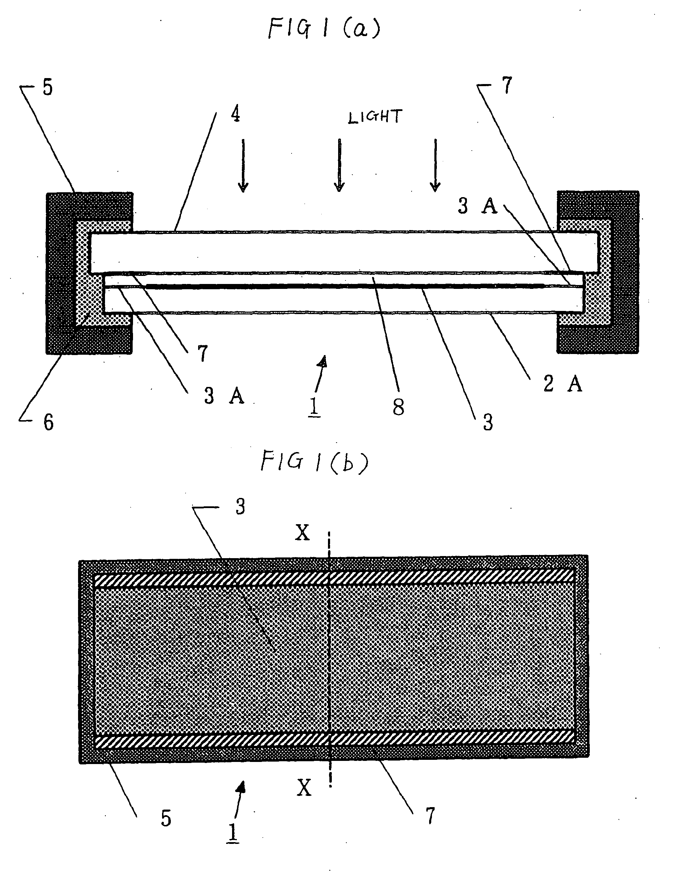

[Fig. 1] Fig. 1 (a) is a view illustrating the constitution of a black-ceramic-decorated solar cell module 1 (CIS based thin-film solar cell module) according to the invention (sectional view; view showing a section formed by cutting along X-X in the plan view (b)). Fig. 1 (b) is a view (plan view) illustrating the constitution of the black-ceramic-decorated solar cell module.
[Fig. 2] Fig. 2 is a view (sectional view) illustrating the constitution of a CIS based thin-film solar cell device which is part of the components of a black-ceramic-decorated solar cell module according to the invention.
[Fig. 3] Fig. 3 (a) is a view illustrating the constitution of a conventional CIS based thin-film solar cell module (sectional view; view showing a section formed by cutting along X-X in the plan view (b)). Fig. 3 (b) is a view (plan view) illustrating the constitution of the conventional CIS based thin-film solar cell module.

### DESCRIPTION OF REFERENCE NUMERALS AND SIGNS

1 black-ceramic-decorated solar cell module (CIS based thin-film solar cell module) according to the invention
1A conventional CIS based thin-film solar cell module
2 CIS based thin-film solar cell device
2A glass substrate
2B alkali barrier layer
2C metallic back electrode layer
2D p-type CIS light absorption layer
2E high-resistance buffer layer
2F n-type window layer (transparent conductive film)
3 CIS based thin-film solar cell submodule
3A electrode part
4 cover glass
5 aluminum frame
6 sealing material
7 black ceramic layer

### BEST MODE FOR CARRYING OUT THE INVENTION

Embodiments of the invention are explained below. The solar cell module of the invention is a black-ceramic-decorated solar cell module having a beautiful appearance in which the CIS based thin-film solar cell submodule has the same color as the electrode parts of the submodule. The electrode parts formed in peripheral areas of the CIS based thin-film solar cell submodule have a silver-white color, which differs from the black color of the power generation part of the submodule. There has hence been a problem that the module as a whole does not have an even color throughout and module installation results in an impaired appearance.

As shown in Fig. 1, the black-ceramic-decorated solar cell module 1 of the invention has a basic constitution including: a CIS based thin-film solar cell submodule 3 composed of CIS based thin-film solar cell devices 2 (see Fig. 2) electrically connected by patterning; a cover glass 4 bonded to the submodule 3 through a thermally crosslinked EVA resin film (not shown) as an adhesive; and an aluminum frame 5 attached to the periphery of the submodule/cover glass assembly through a sealing material 6. This module 1 may have a structure which includes a back sheet bonded to the back side of the glass substrate 2A through a thermally crosslinked EVA resin film (not shown).

The CIS based thin-film solar cell devices 2 each have a basic structure such as that shown in Fig. 2. Each device 2 is a pn heterojunction device having a substrate structure composed of high-quality thin-film layers including an alkali barrier layer 2B (which may be omitted), metallic back electrode layer (generally molybdenum) 2C, p-type CIS light absorption layer 2D, high-resistance buffer layer 2E, and n-type window layer (transparent conductive film) 2F which have been superposed in this order on a glass substrate 2A constituted of a blue flat glass or the like. The light absorption layer 2D is made of a p-type semiconductor such as a thin multinary-compound semiconductor film, in particular, a I-III-VI₂ Group chalcopyrite semiconductor, e.g., copper indium diselenide (CuInSe₂), copper indium gallium diselenide (CuInGaSe₂), copper gallium diselenide (CuGaSe₂), copper indium gallium diselenide-sulfide (Cu(InGa)(SSe)₂), copper indium disulfide (CuInS₂), copper gallium disulfide (CuGaS₂), copper indium gallium disulfide (CuInGaS₂), or copper indium gallium diselenide (CuInGaSe₂) having a thin film of copper indium gallium diselenide-sulfide (Cu(InGa)(SSe)₂) as a surface layer.

The black-ceramic-decorated solar cell module 1 of the invention is a solar cell module having a beautiful appearance in which the CIS based thin-film solar cell submodule 3 has the same color as the electrode parts 3A of the submodule, as shown in Fig. 1. The solar cell module 1 has a structure including: a CIS based thin-film solar cell submodule 3 composed of a glass substrate and, disposed thereon, CIS based thin-film solar cell device parts (see Fig. 2) which each include superposed layers constituted of an alkali barrier layer (which may be omitted), a metallic back electrode layer, a CIS based light absorption layer, a buffer layer, and a window layer in this order and which have been electrically connected to each other with a conductive pattern; and a tempered cover glass 4 disposed over the upper side of the submodule 3. A black ceramic layer 7 having almost the same color as the solar cell submodule is formed in those peripheral edge parts of the back side (lower side) of the cover glass 4 which come into contact with the electrode parts of the solar cell submodule. As a result, the silver-white electrode parts 3A formed in peripheral areas of the solar cell submodule 3 are hidden by the black ceramic layer 7. The whole module 1 hence has an even color throughout and has an improved appearance. In the module shown in Fig. 1 (b), electrode parts 3A have been disposed along the longer sides only of the periphery of the solar cell submodule 3 and, hence, the black ceramic layer 7 also has been formed along the longer sides of the solar cell submodule 3 so as to hide the electrode parts 3A. However, it is necessary to form the black ceramic layer 7 in suitable areas according to the positions of the electrode parts 3A. For example, when the electrode parts 3A have been disposed along the shorter sides of the periphery of the solar cell submodule 3, then the black ceramic layer 7 also is formed along the shorter sides of the periphery of the solar cell submodule 3 so as to hide these electrode parts.
Incidentally, even when the black ceramic layer 7 is formed on the front side (upper side) of the cover glass 4, the effect of imparting an even color is obtained. In this case, however, incident light is partly blocked by the black ceramic layer 7 to cast a shadow on the solar cell submodule 3, resulting in a possibility that the power output of the solar cell might decrease.

The black ceramic layer 7 may be one formed by screen-printing an ink prepared by mixing a glass ingredient and a pigment ingredient with a solvent and then baking the ink applied. The glass ingredient for the black ceramic layer 7 may include at least either of bismuth oxide and diboron trioxide and further include silica (SiO₂) or the like. The pigment ingredient may include at least either of manganese dioxide and chromium oxide. The solvent may include a terpene solvent.

A baking operation for forming the black ceramic layer 7 in peripheral edge parts of the back side (lower side) of the cover glass 4 may be accomplished by conducting a heat treatment simultaneously with the tempering by a heat treatment to be performed in producing the cover glass 4. Consequently, the formation of the black ceramic layer 7 in this manner does not increase the number of solar cell module assembly/production steps.

The cover glass 4 has front and back sides, and the back side has a rough surface. By forming the black ceramic layer 7 on the back side beforehand, the front side and back side of the cover glass 4 can be easily distinguished from each other without fail in an operation for disposing the cover glass 4. Thus, operation efficiency is improved, and the rate of occurrence of defective products can be reduced.

## Claims

1. A black-ceramic-decorated solar cell module which is a solar cell module comprising a structure constituted of: a CIS based thin-film solar cell submodule comprising a glass substrate and, disposed on the glass substrate, CIS based thin-film solar cell device parts which each comprises superposed layers constituted of a metallic back electrode layer, a CIS based light absorption layer, a buffer layer, and a window layer in this order and which have been electrically connected to each other with a conductive pattern; a tempered cover glass disposed over the upper side of the solar cell submodule; and a back sheet disposed on the back side of the glass substrate through a filling material,
wherein the cover glass has a black ceramic layer which has almost the same color as the solar cell submodule and is located in a peripheral edge part on at least one side of the cover glass and over a silver-white electrode part formed in a peripheral area of the solar cell submodule to thereby hide the electrode part.

2. The black-ceramic-decorated solar cell module according to claim 1, wherein the black ceramic layer has been formed in a peripheral edge part on that side of the cover glass which is in contact with the electrode part of the solar cell submodule.

3. The black-ceramic-decorated solar cell module according to claim 1 or 2, wherein the black ceramic layer is one formed by screen-printing an ink prepared by mixing a glass ingredient and a pigment ingredient with a solvent and baking the ink applied.

4. The black-ceramic-decorated solar cell module according to claim 3, wherein the glass ingredient for the black ceramic layer comprises at least either of bismuth oxide and diboron trioxide, and silica (SiO₂) or the like, the pigment ingredient comprises at least either of manganese dioxide and chromium oxide, and the solvent comprises a terpene solvent.

5. The black-ceramic-decorated solar cell module according to any one of claims 1 to 4, wherein the baking for forming the black ceramic layer is conducted by utilizing the heating performed when the tempered cover glass is produced through tempering by a heat treatment.
